(19) Europäisches Patentamt / European Patent Office / Office européen des brevets

(11) **EP 3 385 737 A1**

(12) **EUROPEAN PATENT APPLICATION**
published in accordance with Art. 153(4) EPC

(43) Date of publication:
**10.10.2018 Bulletin 2018/41**

(51) Int Cl.:
*G01R 31/36* (2006.01)      *G01R 27/02* (2006.01)
*H01M 10/42* (2006.01)      *H01M 10/48* (2006.01)

(21) Application number: **16870696.8**

(22) Date of filing: **30.11.2016**

(86) International application number:
**PCT/JP2016/085509**

(87) International publication number:
**WO 2017/094759 (08.06.2017 Gazette 2017/23)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **30.11.2015   JP 2015234007**
**26.07.2016   JP 2016146626**

(71) Applicant: **Sekisui Chemical Co., Ltd.**
**Osaka-shi, Osaka 530-8565 (JP)**

(72) Inventor: **ATAKA Motoharu**
**Tsukuba-shi**
**Ibaraki 300-4292 (JP)**

(74) Representative: **Müller-Boré & Partner**
**Patentanwälte PartG mbB**
**Friedenheimer Brücke 21**
**80639 München (DE)**

(54) **METHOD FOR DETERMINING DIAGNOSIS FREQUENCY, METHOD FOR DIAGNOSING DETERIORATION OF STORAGE CELL, SYSTEM FOR DETERMINING DIAGNOSIS FREQUENCY, AND DEVICE FOR DIAGNOSING DETERIORATION OF STORAGE CELL**

(57)     A method for determining a diagnosis frequency is configured to perform an impedance measurement step of measuring impedance of a storage cell corresponding to each predetermined frequency in association with progress of deterioration of the storage cell, and a diagnosis frequency determination step of determining a frequency corresponding to impedance having a characteristic variation in value with respect to the progress of deterioration, among the impedances measured in the impedance measurement step, as a diagnosis frequency for use in measurement based on an AC impedance method for performing a deterioration diagnosis on the storage cell.

## FIG. 1

EP 3 385 737 A1

## Description

## Technical Field

The present invention relates to a method for determining a diagnosis frequency, a method for diagnosing deterioration of a storage cell, a system for determining a diagnosis frequency and a device for diagnosing deterioration of a storage cell.

Priority is claimed on Japanese Patent Application Nos. 2015-234007 filed on November 30, 2015 and 2016-146626 filed on July 26, 2016, the contents of which are incorporated herein by reference.

## Background Art

The following method of diagnosing the state of a secondary battery (storage cell) has been known. That is, in this state diagnosis method, real characteristics are calculated by making a real part and an imaginary part of impedance of a storage cell, measured for each of a plurality of frequencies, approximate to an equivalent circuit model, on the basis of an AC impedance method. A determination is made of whether the storage cell is a normal product or a defective product on the basis of the result of comparison of a real characteristic value with a logic characteristic value (see, for example, PTL 1).

However, in the AC impedance method as stated above, impedance is measured for each of a plurality of frequencies, and thus it takes a lot of time until the measurement of all frequencies is terminated. For this reason, it takes a lot of time to diagnose the state of the storage cell using the AC impedance method.

Consequently, a technique has been known in which, when an overcharge state corresponding to a specific pack-type storage cell is diagnosed, a frequency indicating a variation corresponding to the overcharge state among frequencies based on an AC impedance method is specified, and the specified frequency is used (see, for example, NPL 1).

## Citation List

## Patent Literature

[PTL 1] Japanese Unexamined Patent Application, First Publication No. 2014-134467

## Non-Patent Literature

[NPL 1] Corey T. Love, Maheboob B.V. Virji, Richard E. Rocheleau, Karen E. Swider-Lyons "State-of-health monitoring of 18650 4S packs with a single-point impedance diagnostic", 20 May 2014, Journal of Power Sources 266(2014), p.512-519

## Summary of Invention

## Technical Problem

An AC impedance method is also used in a deterioration diagnosis for diagnosing the deterioration state of a storage cell. The technique disclosed in NPL 1 is to specify a frequency suitable for the overcharge state of a storage cell rather than the deterioration state thereof. For this reason, in a method of specifying a frequency in NPL 1, it is difficult to specify a frequency suitable for the deterioration diagnosis of a storage cell from frequencies used in an AC impedance method.

The present invention is contrived in view of such circumstances, and an object thereof is to make it possible to accurately specify a frequency suitable for the deterioration diagnosis of a storage cell.

## Solution to Problem

According to an aspect of the present invention to solve the above problem, there is provided a method for determining a diagnosis frequency, including: an impedance measurement step of measuring impedance of a storage cell corresponding to each predetermined frequency in association with progress of deterioration of the storage cell; and a diagnosis frequency determination step of determining a frequency corresponding to impedance having a characteristic variation in value with respect to the progress of deterioration, among the impedances measured in the impedance measurement step, as a diagnosis frequency for use in measurement based on an AC impedance method for performing a deterioration diagnosis on the storage cell.

According to an aspect of the present invention, there is provided a method for diagnosing deterioration of a storage cell, including: an impedance measurement step of measuring impedance by applying a signal, based on a diagnosis frequency determined using the method for determining a diagnosis frequency, to a storage cell; and a deterioration diagnosis step of performing a deterioration diagnosis of the storage cell by collating deterioration index information indicating the impedance measured on the basis of the diagnosis frequency in accordance with a degree of deterioration of the storage cell with the impedance measured in the impedance measurement step.

According to an aspect of the present invention, there is provided a system for determining a diagnosis frequency, including: an impedance measurement unit that measures impedance of a storage cell corresponding to each predetermined frequency in association with progress of deterioration of the storage cell; and a diagnosis frequency determination unit that determines a frequency corresponding to impedance having a characteristic variation in value with respect to the progress of deterioration, among the impedances measured by the impedance measurement unit, as a diagnosis frequency for use in measurement based on an AC impedance method for performing a deterioration diagnosis on the storage cell.

According to an aspect of the present invention, there is provided a system for determining a diagnosis frequency, including: a storage unit that stores measurement values obtained by measuring a state of a storage cell; and an arithmetic operation unit that determines a frequency corresponding to a measurement value having a characteristic variation with respect to progress of deterioration of the storage cell, among the measurement values stored by the storage unit, as a diagnosis frequency for use in a diagnosis of the deterioration of the storage cell.

According to an aspect of the present invention, there is provided a device for diagnosing deterioration of a storage cell, including: an impedance measurement unit that measures impedance by applying a signal, based on a diagnosis frequency determined by the system for determining a diagnosis frequency, to a storage cell; and a deterioration diagnosis unit that performs a deterioration diagnosis of the storage cell by collating deterioration index information indicating the impedance measured on the basis of the diagnosis frequency in accordance with a degree of deterioration of the storage cell with the impedance measured by the impedance measurement unit.

The present invention has the following aspects.

[1] A method for determining a diagnosis frequency, including:

an impedance measurement step of measuring impedance of a storage cell corresponding to each predetermined frequency in association with progress of deterioration of the storage cell; and

a diagnosis frequency determination step of determining a frequency corresponding to impedance having a characteristic variation in value with respect to the progress of deterioration, among the impedances measured in the impedance measurement step, as a diagnosis frequency for use in measurement based on an AC impedance method for performing a deterioration diagnosis on the storage cell.

[2] The method for determining a diagnosis frequency according to [1], wherein the diagnosis frequency determination step includes

a fitting step of fitting the impedance measured in the impedance measurement step to an equivalent circuit corresponding to the storage cell,

an element specification step of specifying an element of which a parameter characteristically varies with respect to the progress of deterioration, among elements that form the equivalent circuit fitted in the fitting step,

a frequency candidate determination step of determining a candidate for a diagnosis frequency on the basis of a frequency having a characteristic response of a circuit including the element specified in the element specification step, and

a diagnosis frequency selection step of selecting a candidate for a diagnosis frequency corresponding to impedance having a characteristic variation in value with respect to the progress of deterioration, among impedances measured in response to each candidate for a diagnosis frequency determined in the frequency candidate determination step, as a diagnosis frequency.

[3] The method for determining a diagnosis frequency according to [1], wherein the diagnosis frequency determination step includes

a plot information output step of outputting plot information for each predetermined frequency which is obtained by plotting the impedance measured in the impedance measurement step in association with the progress of deterioration, and

an acceptance step of accepting selection of a diagnosis frequency from a plurality of frequencies corresponding to each output plot information.

[4] A method for diagnosing deterioration of a storage cell, including:

an impedance measurement step of measuring impedance by applying a signal, based on a diagnosis frequency determined using the method for determining a diagnosis frequency according to any one of [1] to [3], to a storage cell; and

a deterioration diagnosis step of performing a deterioration diagnosis of the storage cell by collating deterioration index information indicating the impedance measured on the basis of the diagnosis frequency in accordance with a degree of deterioration of the storage cell with the impedance measured in the impedance measurement step.

[5] The method for diagnosing deterioration of a storage cell according to [4], wherein the deterioration index information indicates the impedance measured on the basis of the diagnosis frequency in accordance with the degree of deterioration of the storage cell in association with each charge state of the storage cell, and

wherein in the deterioration diagnosis step, a deterioration diagnosis of the storage cell is performed by collating impedance according to the degree of deterioration of the storage cell indicated in the deterioration index information in response to the charge state detected in the storage cell with the impedance measured in the impedance measurement step.

[6] A system for determining a diagnosis frequency, including:

an impedance measurement unit that measures impedance of a storage cell corresponding to each predetermined frequency in association with progress of deterioration of the storage cell; and

a diagnosis frequency determination unit that determines a frequency corresponding to impedance having a characteristic variation in value with respect to the progress of deterioration, among the impedances measured by the impedance measurement unit, as a diagnosis frequency for use in measurement based on an AC impedance method for performing a deterioration diagnosis on the storage cell.

[7] A system for determining a diagnosis frequency, including:

a storage unit that stores measurement values obtained by measuring a state of a storage cell; and

an arithmetic operation unit that determines a frequency corresponding to a measurement value having a characteristic variation with respect to progress of deterioration of the storage cell, among the measurement values stored by the storage unit, as a diagnosis frequency for use in a diagnosis of the deterioration of the storage cell.

[8] The system for determining a diagnosis frequency according to [7], wherein the measurement value is characteristics of the storage cell which are measured in accordance with application of a signal to the storage cell.

[9] The system for determining a diagnosis frequency according to claim [8], wherein the characteristics of the storage cell are response characteristics of the storage cell which are measured in accordance with application of a signal to the storage cell.

[10] The system for determining a diagnosis frequency according to claim [9], wherein the response characteristics of the storage cell are impedance of the storage cell which is measured in a state where a signal is applied to the storage cell.

[11] A device for diagnosing deterioration of a storage cell, including:

an impedance measurement unit that measures impedance by applying a signal, based on a diagnosis frequency determined by the system for determining a diagnosis frequency according to any one of [6] to [10], to a storage cell; and

a deterioration diagnosis unit that performs a deterioration diagnosis of the storage cell by collating deterioration index information indicating the impedance measured on the basis of the diagnosis frequency in accordance with a degree of deterioration of the storage cell with the impedance measured by the impedance measurement unit.

Advantageous Effects of Invention

As described above, according to the present invention, an effect is obtained in which it is possible to accurately specify a frequency suitable for the deterioration diagnosis of the storage cell from frequencies used in an AC impedance method.

Brief Description of Drawings

FIG. 1 is a diagram illustrating a configuration example of a system for determining a diagnosis frequency in a first embodiment.
FIG. 2 is a diagram illustrating an example of an equivalent circuit of a storage cell used in fitting in the first embodiment.
FIG. 3 is a diagram illustrating a specific example of results of fitting by a fitting unit in a first embodiment.
FIG. 4 is a diagram graphically illustrating the resistance value of each resistor and the degree of deterioration according to a charge and discharge cycle number shown in FIG. 3.
FIG. 5 is a diagram illustrating a Cole-Cole plot of three impedances according to every three specific conditions from measurement results of impedances based on the fitting results of FIG. 3.
FIG. 6 is a diagram illustrating a Cole-Cole plot obtained by enlarging a portion corresponding to a region indicated by a broken line in the Cole-Cole plot of FIG. 5.
FIG. 7 is a Bode diagram of impedances according to every three conditions which are the same as those in FIGS. 5 and 6 from the measurement results of impedances based on the fitting results of FIG. 3.
FIG. 8 is a diagram illustrating variations according to the charge and discharge cycle number of a real part of impedance measured for each measurement frequency of candidates for the diagnosis frequency in the first embodiment.
FIG. 9 is a diagram illustrating variations according to the charge and discharge cycle number of an imaginary part of impedance measured for each measurement frequency of the candidates for the diagnosis frequency in the first embodiment.
FIG. 10 is a diagram illustrating variations according to the charge and discharge cycle number of an absolute value of impedance measured for each measurement frequency of the candidates for the diagnosis frequency in the first embodiment.
FIG. 11 is a flow diagram illustrating an example of a processing procedure executed by the system for determining a diagnosis frequency in the first embodiment in order to determine the diagnosis frequency corresponding to a storage cell.

FIG. 12 is a diagram illustrating a configuration example of a power storage device in the first embodiment.

FIG. 13 is a diagram illustrating a content example of deterioration index information in the first embodiment.

FIG. 14 is a flow diagram illustrating an example of a processing procedure executed by a device for diagnosing deterioration of a storage cell in the first embodiment.

FIG. 15 is a diagram illustrating a configuration example of a device for diagnosing deterioration of a storage cell in a second embodiment.

FIG. 16 is a diagram illustrating a configuration example of a system for determining a diagnosis frequency in a first modification example of the present embodiment.

FIG. 17 is a diagram illustrating a configuration example of a system for determining a diagnosis frequency in a second modification example of the present embodiment.

Description of Embodiments

<First Embodiment>

[System for Determining Diagnosis Frequency]

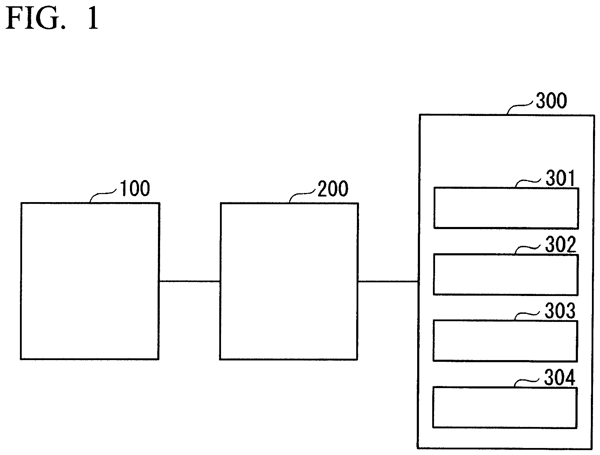

FIG. 1 shows a configuration example of a system for determining a diagnosis frequency in the present embodiment. The system for determining a diagnosis frequency in the present embodiment is a system for determining (specifying) a single frequency used in performing a deterioration diagnosis for detecting the deterioration (an example of the state of a storage cell) of a storage cell (secondary battery) using an AC impedance method.

The system for determining a diagnosis frequency in the present embodiment includes a storage cell 100, an impedance measurement device 200, and a device for determining a diagnosis frequency 300.

The storage cell 100 accumulates power which is input for charge, and can output the accumulated power through discharge. The storage cell 100 in the present embodiment is, for example, a lithium-ion battery. The storage cell 100 in the drawing is a storage cell in which impedance measurement using an AC impedance method is performed in order to determine a diagnosis frequency, and has the same type as that of a storage cell which is a target for deterioration diagnosis.

The impedance measurement device 200 is a device that measures the impedance of the storage cell 100 using an AC impedance method. The impedance measurement device 200 can be configured to include, for example, a potentio-galvanostat, a frequency response analyzer (FRA) and the like.

The impedance measurement device 200 in the system for determining a diagnosis frequency measures impedance using a general AC impedance method. That is, the impedance measurement device 200 is configured such that, while an alternating-current voltage or an alternating current is applied to the storage cell 100 at a plurality of frequencies (measurement frequencies) in a constant frequency range, the impedance of the storage cell 100 can be measured in response to each of the frequencies.

The impedance measurement device 200 of the present embodiment measures the impedance of the storage cell corresponding to each of the plurality of predetermined measurement frequencies for each predetermined charge and discharge cycle number, using an AC impedance method.

The device for determining a diagnosis frequency 300 determines a measurement frequency corresponding to impedance, having a characteristic variation in value with respect to a deterioration progress index value among the impedances measured by the impedance measurement device 200, as a diagnosis frequency for use in measurement based on an AC impedance method for performing a deterioration diagnosis on the storage cell 100. In the present embodiment, the characteristic variation in the value of impedance with respect to the deterioration progress index value refers to a variation in the value of impedance being remarkable. More specifically, the degree of variation in the value of impedance corresponding to a certain measurement frequency refers to being larger than the degree of variation in the value of impedance corresponding to other measurement frequencies.

The term "deterioration progress index value" as used herein refers to a value indicating the state of a storage cell, and to a value corresponding to the progress of deterioration based on a predetermined deterioration factor of the storage cell. The storage cell deteriorates by being operated so that charge and discharge are performed, and deteriorates even in the state of maintenance in which discharge is performed without charge and discharge. Therefore, examples of the deterioration progress index value include a charge and discharge cycle number, an operating time (charge time, discharge time), a maintenance time (time at which a charge and discharge operation is stopped), an amount of accumulated charge, an amount of accumulated discharge, and the like. In the present embodiment, the deterioration progress index value adopted in the determination of a diagnosis frequency may be, for example, any of the values stated above. In the following description of the present embodiment, a case where the deterioration progress index value is a charge and discharge cycle number is given as an example.

The device for determining a diagnosis frequency 300 in the drawing includes a fitting unit 301, an element specification unit 302, a frequency candidate determination unit 303 and a diagnosis frequency selection unit 304.

The fitting unit 301 fits impedance measured by the impedance measurement device 200 to an equivalent circuit corresponding to the storage cell 100.

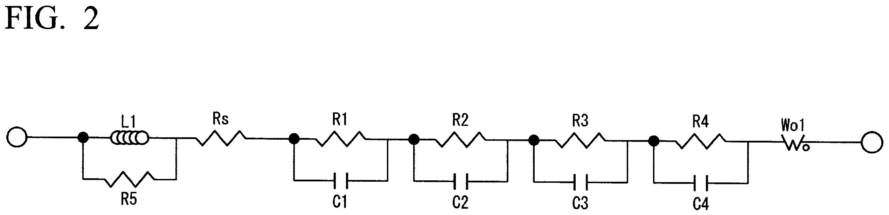

FIG. 2 is an example of an equivalent circuit of the storage cell 100 used in fitting. The equivalent circuit in the drawing is configured such that a parallel circuit consisting of an inductance L1 and a resistor R5, a resistor RS, a parallel circuit (CR circuit) consisting of a resistor R1 and a capacitance C1, a parallel circuit consisting of a resistor R2 and a capacitance C2, a parallel circuit consisting of a resistor R3 and a capacitance C3, a parallel circuit consisting of a resistor R4 and a capacitance C4 and a Warburg impedance Wo1 are connected to each other in order from an input terminal to an output terminal.

Description is given referring back to FIG. 1. The element specification unit 302 specifies an element having a most remarkable variation in constant with respect to the deterioration progress index value (herein, charge and discharge cycle number) among the elements that form the equivalent circuit of FIG. 2 fitted by the fitting unit 301. In the present embodiment, the elements that form the equivalent circuit are elements such as a resistor, an inductance, and a capacitance that form the equivalent circuit. Moreover, the element specification unit 302 of the present embodiment sets a resistor out of the elements that form the equivalent circuit of FIG. 2 as a specific candidate, and specifies a resistor having a most remarkable variation in resistance value (an example of a parameter) with respect to the charge and discharge cycle number.

The frequency candidate determination unit 303 determines a candidate for a diagnosis frequency from measurement frequencies on the basis of the cutoff frequency of a circuit (RC circuit) including the element (resistor) specified by the element specification unit 302.

The diagnosis frequency selection unit 304 selects (determines), as a diagnosis frequency, a candidate for a diagnosis frequency corresponding to impedance having a remarkable variation in value with respect to the charge and discharge cycle number among the impedances measured in response to each candidate for the diagnosis frequency determined by the frequency candidate determination unit 303.

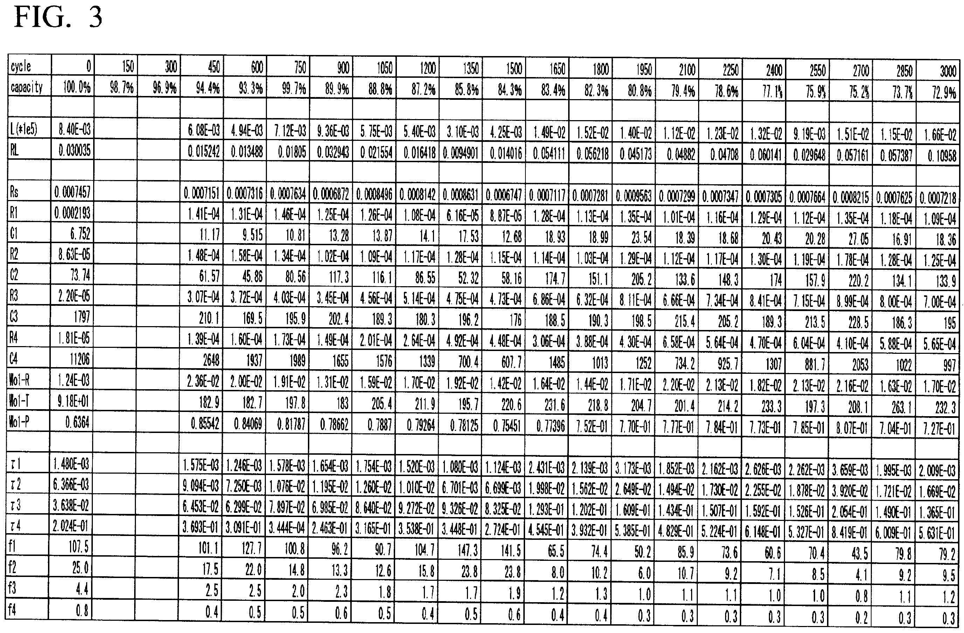

Subsequently, reference will be made to FIGS. 3 to 8 to describe an example of a procedure performed by the system for determining a diagnosis frequency in the present embodiment in order to determine a diagnosis frequency.

First, the storage cell 100 is operated so as to repeat charge and discharge from the state of a new product. For example, the storage cell 100 is repeatedly charged and discharged until the charge and discharge cycle number is set from "0 times" to "3,000 times".

Moreover, the impedance measurement device 200 measures impedance by applying an alternating current corresponding to each of a plurality of predetermined measurement frequencies at each predetermined charge and discharge cycle number. Here, the plurality of measurement frequencies can be determined in a range of, for example, 0.01 Hz to 100 kHz.

Such measurement is performed by the impedance measurement device 200, and thus impedance measured for each measurement frequency is obtained in response to each predetermined charge and discharge cycle number.

Next, the fitting unit 301 performs fitting for converting impedance corresponding to the charge and discharge cycle number and the measurement frequency, measured and obtained by the impedance measurement device 200 as described above, into the constant of each of the elements in the equivalent circuit of FIG. 2. Regarding the process of fitting, for example, methods having been known so far may be adopted.

FIG. 3 shows a specific example of results of fitting by the fitting unit 301. In the drawing, the "cycle" indicates a charge and discharge cycle number.

As shown in the drawing, as the results of fitting by the fitting unit 301, the constant of each of the elements (L1, R5, R1, C1, R2, C2, R3, C3, R4, C4, Wo1 (Wo1-R, Wo1-T, Wo1-P)) included in the equivalent circuit of FIG. 2 is obtained for each charge and discharge cycle number.

Meanwhile, a method (procedure) of fitting by the fitting unit 301 in the present embodiment is not limited to the above example. For example, equivalent circuits used in fitting may be circuits other than that shown in FIG. 2. In addition, regarding mathematical expressions or the like used in an arithmetic operation for obtaining the constant of an equivalent circuit in fitting, mathematical expressions other than those obtained as the results of FIG. 3 may also be adopted.

In the drawing, the capacity retention rate (Capacity) of the storage cell measured in response to each charge and discharge cycle number is shown. The capacity retention rate indicates how much maximum dischargeable capacity is maintained with respect to maximum dischargeable capacity when the charge and discharge cycle number is 0 times, at charge and discharge cycle numbers after that. That is, the capacity retention rate indicates the degree of deterioration of the storage cell 100. As the capacity retention rate becomes lower, the degree of deterioration increases. The capacity retention rate is also called a state of health (SOH).

The element specification unit 302 sets, for example, the resistors R1, R2, R3, and R4 to specific candidates among the constants of elements obtained as in FIG. 3, and specifies a resistor (hereinafter, also referred to as a "response resistor") having a most remarkable variation in resistance value (constant) with respect to the charge and discharge cycle number from these specific candidates. Examples of the specific candidates also include the capacitances C1, C2, C3, and C4, or the like. However, here, a case where the resistors R1, R2, R3, and R4 are set to specific candidates will be described in response to a case where the degree of appearance of a variation in constant in the resistor rather than the capacitance is high.

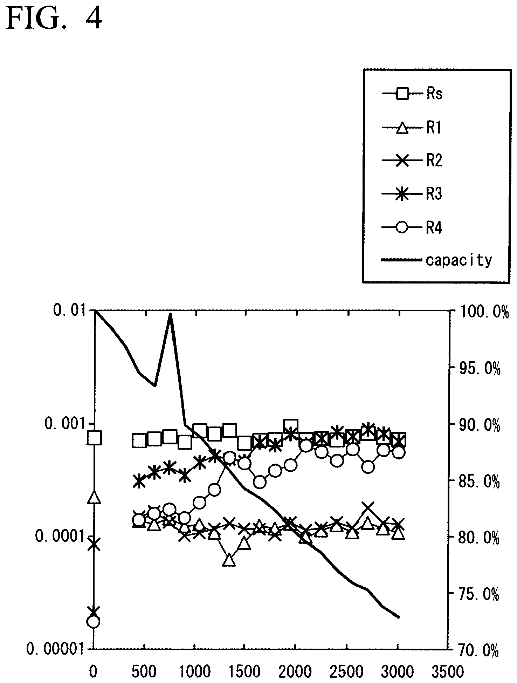

FIG. 4 graphically shows the resistance value of each of the resistors R1, R2, R3, and R4 and the degree of deterioration according to the charge and discharge cycle number shown in FIG. 3. As understood from the drawing, the capacity retention rate shows a tendency to decrease with the progress of charge and discharge and an increase in the charge and discharge cycle number.

According to the drawing, the resistor R4 has a most remarkable variation in resistance value with respect to an increase in the charge and discharge cycle number, that is, the deterioration of the storage cell 100, among the resistors R1, R2, R3, and R4. The element specification unit 302 calculates a rate of variation with respect to the charge and discharge cycle number for each of the resistors R1, R2, R3, and R4, for example, using the fitting results. A resistor having a largest calculated rate of variation is selected as a response resistor. In this manner, the response resistor is specified by the element specification unit 302. In a case where the fitting results are as shown in FIG. 3, the element specification unit 302 specifies that the response resistor is the resistor R4.

In a case where it is specified that the response resistor is the resistor R4 as described above, the frequency candidate determination unit 303 calculates the cutoff frequency f4 of the parallel circuit (CR circuit) consisting of the resistor R4 which is a response resistor and the capacitance C4 in the equivalent circuit (FIG. 2). The cutoff frequency f4 in this case is obtained by the following expression.

$$f4 = 1/2\pi \cdot R4 \cdot C4$$

For reference for the purpose of comparison, FIG. 3 shows the cutoff frequency f1 of the CR circuit consisting of the resistor R1 and the capacitance C1, the cutoff frequency f2 of the CR circuit consisting of the resistor R2 and the capacitance C2 and the cutoff frequency f3 of the CR circuit consisting of the resistor R3 and the capacitance C3, together with the cutoff frequency f4 of the CR circuit consisting of the resistor R4 and the capacitance C4. In a case where the cutoff frequencies f1 to f4 in the drawing are compared with each other, the cutoff frequency f4 has a lowest variation with respect to the charge and discharge cycle number. With an increase in the charge and discharge cycle number, the cutoff frequencies in this case show an increase in the constant of the resistor R4, and a decrease in the constant of the capacitance C4.

The drawing shows, for reference, the time constant τ1 of the CR circuit consisting of the resistor R1 and capacitance C1, the time constant τ2 of the CR circuit consisting of the resistor R2 and capacitance C2, the time constant τ3 of the CR circuit consisting of the resistor R3 and capacitance C3 and the time constant τ4 of the CR circuit consisting of the resistor R4 and capacitance C4.

Here, the cutoff frequency f4 of the CR circuit consisting of the resistor R4 and the capacitance C4 stabilizes in a range of 0.6 Hz to 0.3 Hz with respect to the charge and discharge cycle number of "0 times" to "3,000 times", and stabilizes at substantially 0.3 Hz in response to the charge and discharge cycle number of 1,800 times or less. This corresponds to the fact that, among impedances measured for each measurement frequency in a range of 0.01 Hz to 100 kHz described above, impedance measured at a measurement frequency around 0.3 Hz shows a remarkable variation in response to deterioration (decrease in the capacity retention rate) of the storage cell. That is, in this case, the measurement frequency around 0.3 Hz is set to a candidate for a diagnosis frequency.

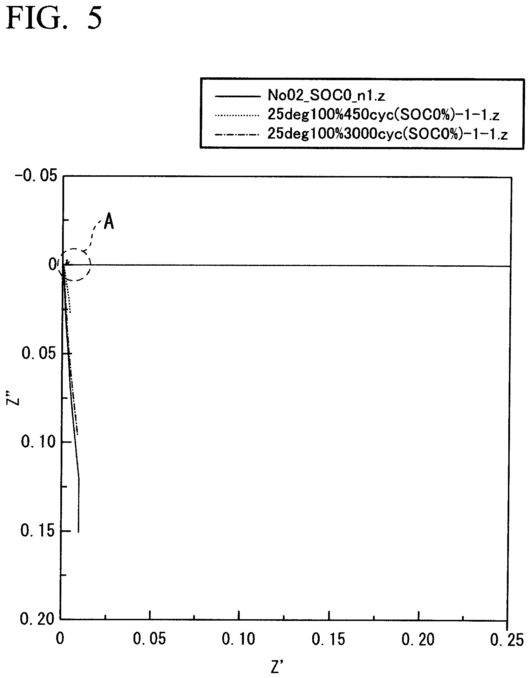

FIG. 5 shows a Cole-Cole plot of three impedances according to every three specific conditions from the measurement results of impedances based on the fitting results of FIG. 3. In the Cole-Cole plot, the horizontal axis represents the real part Z' of impedance, and the vertical axis represents the imaginary part Z" of impedance.

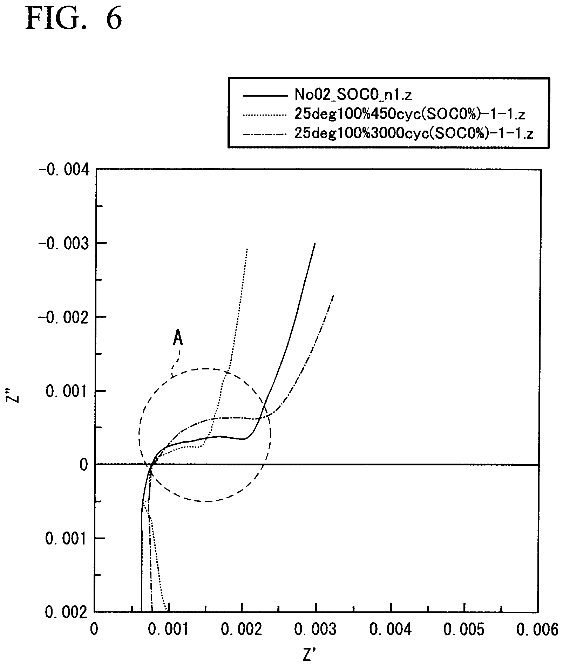

FIG. 6 is a Cole-Cole plot obtained by enlarging a portion corresponding to a region A indicated by a broken line in the Cole-Cole plot of FIG. 5. In this case, the measurement frequency around 0.3 Hz which is set to a candidate for a diagnosis frequency corresponds to the measurement results of the impedance of a portion corresponding to the region A in the drawing.

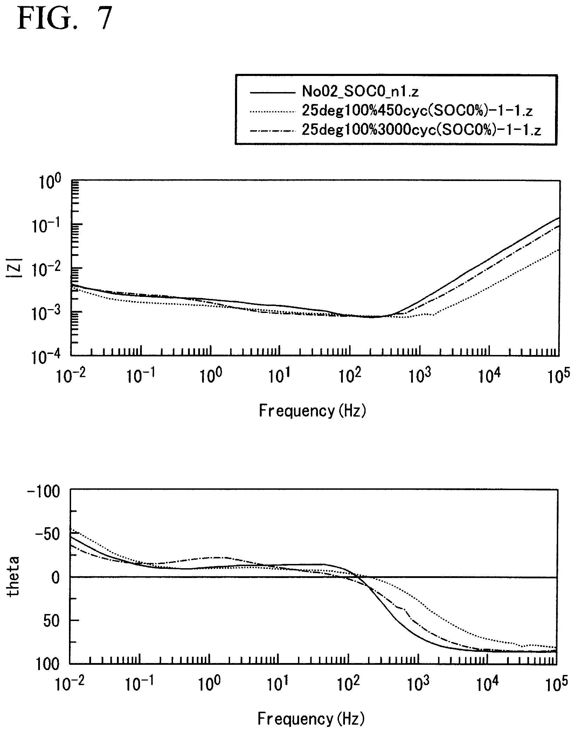

For reference, FIG. 7 is a Bode diagram of impedances according to every three conditions which are the same as those in FIGS. 5 and 6 from the measurement results of impedances based on the fitting results of FIG. 3. The upper Bode diagram in the drawing shows an absolute value |Z| of impedance according to the measurement frequency, and the lower Bode diagram shows a phase difference (θ) according to the measurement frequency.

On the basis of such a speculation, the frequency candidate determination unit 303 can determine a candidate for a diagnosis frequency, as an example, as follows. The frequency candidate determination unit 303 calculates the cutoff frequency f4 of the CR circuit including the resistor R4 which is a response resistor for each charge and discharge cycle number, and derives one reference frequency using, for example, a method such as the generation of a normal distribution, the calculation of an average value, the specification of a mode, or the like, with respect to the calculated cutoff frequency f4. The frequency candidate determination unit 303 determines measurement frequencies included in a certain range, based on the derived reference frequency, as candidates for a diagnosis frequency.

The diagnosis frequency selection unit 304 compares rates of variation according to a charge and discharge cycle between impedances corresponding to each measurement frequency determined as the candidate for a diagnosis frequency as described above.

As a result of the comparison, the diagnosis frequency selection unit 304 determines one measurement frequency corresponding to impedance determined as having a largest rate of variation, as a diagnosis frequency.

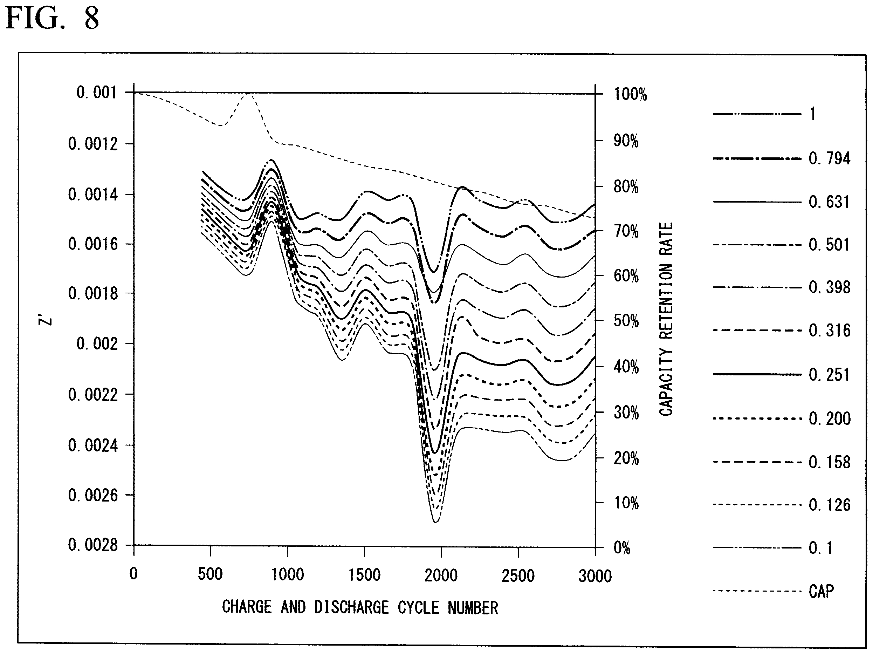

FIG. 8 shows variations according to the charge and discharge cycle number of a real part of impedance measured for each measurement frequency of a candidate, on the basis of a case where the measurement frequency in a range of 1 Hz to 0.1 Hz is determined as the candidate for a diagnosis frequency.

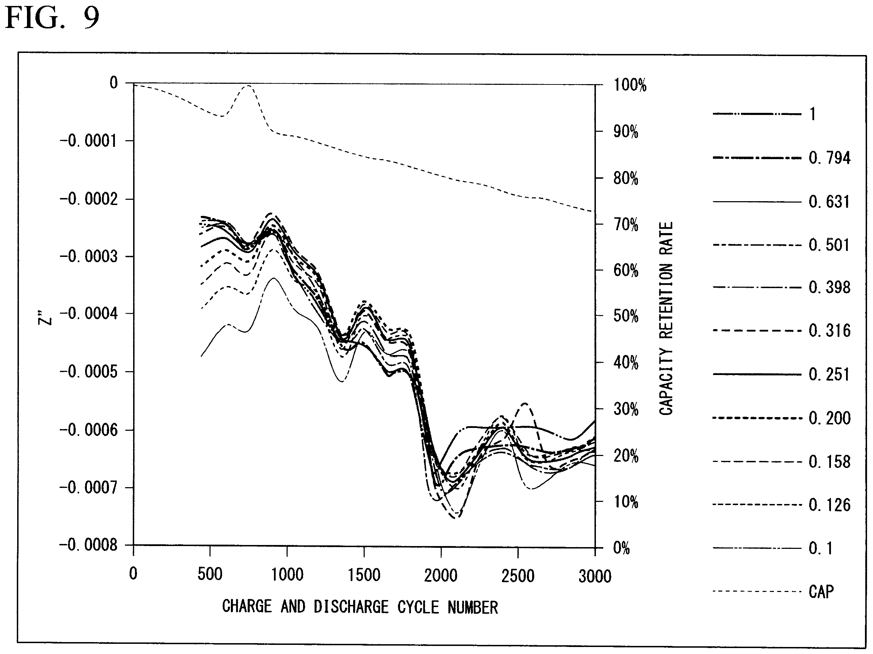

FIG. 9 shows variations according to the charge and discharge cycle number of an imaginary part of impedance measured for each measurement frequency of a candidate, on the basis of a case where the measurement frequency in a range of 1 Hz to 0.1 Hz which is the same as that in FIG. 8 is determined as the candidate for a diagnosis frequency.

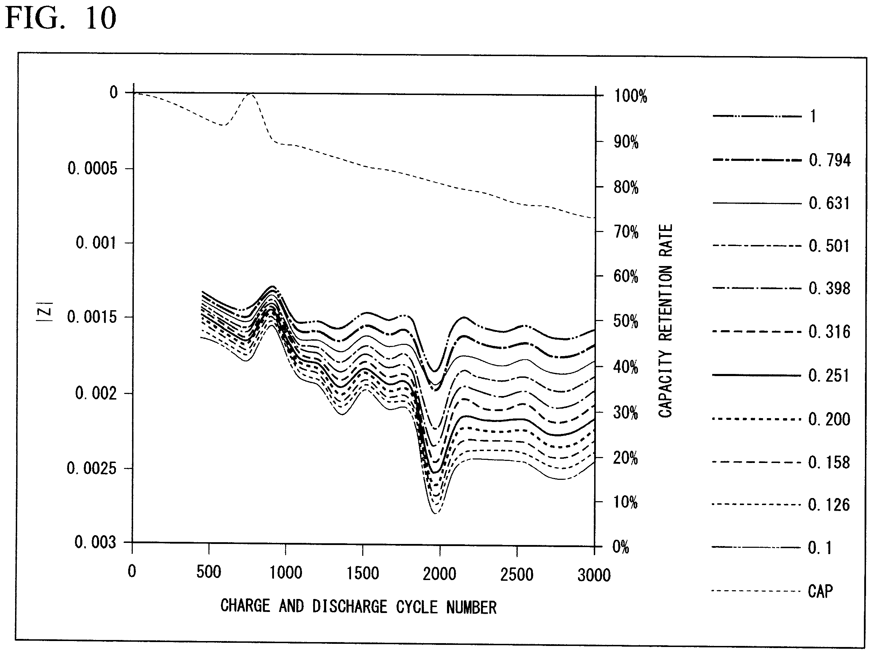

FIG. 10 shows variations according to the charge and discharge cycle number of the absolute value of impedance measured for each measurement frequency of a candidate, on the basis of a case where the measurement frequency in a range of 1 Hz to 0.1 Hz which is the same as that in FIG. 8 is determined as the candidate for a diagnosis frequency.

FIGS. 8, 9, and 10 show that the characteristics of the real part of impedance in FIG. 8 and the characteristics of the absolute value of impedance in FIG. 10 are approximate to each other, and that as the measurement frequency of a candidate becomes lower, variations according to the charge and discharge cycle number becomes larger. On the other hand, in the imaginary part of impedance shown in FIG. 9, the characteristics such as those in FIGS. 8 and 10 do not appear. Consequently, in this case, a measurement frequency corresponding to impedance having a largest variation with respect to the charge and discharge cycle number among the measurement frequencies of candidates is specified to be 0.1 Hz, on the basis of the characteristics of FIG. 8 or 10. Therefore, in this case, 0.1 Hz can be selected as a diagnosis frequency.

On the basis of such a speculation, the diagnosis frequency selection unit 304 can perform a process of selecting a diagnosis frequency, as an example, as follows.

First, a determination is previously made as to which of the real part, the imaginary part and the absolute value is adopted as the component of impedance (effective impedance component) used in the selection of a diagnosis frequency in response to the storage cell 100. In cases of FIGS. 8 to 10, it is determined that any one of the real part and the absolute value of impedance is adopted as the effective impedance component. As the effective impedance component, a plurality of components may be adopted.

Moreover, the diagnosis frequency selection unit 304 calculates a rate of variation with respect to the charge and discharge cycle number of an effective impedance component for each measurement frequency in a range of frequencies determined as the candidate for a diagnosis frequency by the frequency candidate determination unit 303. The diagnosis frequency selection unit 304 can select a measurement frequency corresponding to an effective impedance component having a highest calculated rate of variation as a diagnosis frequency.

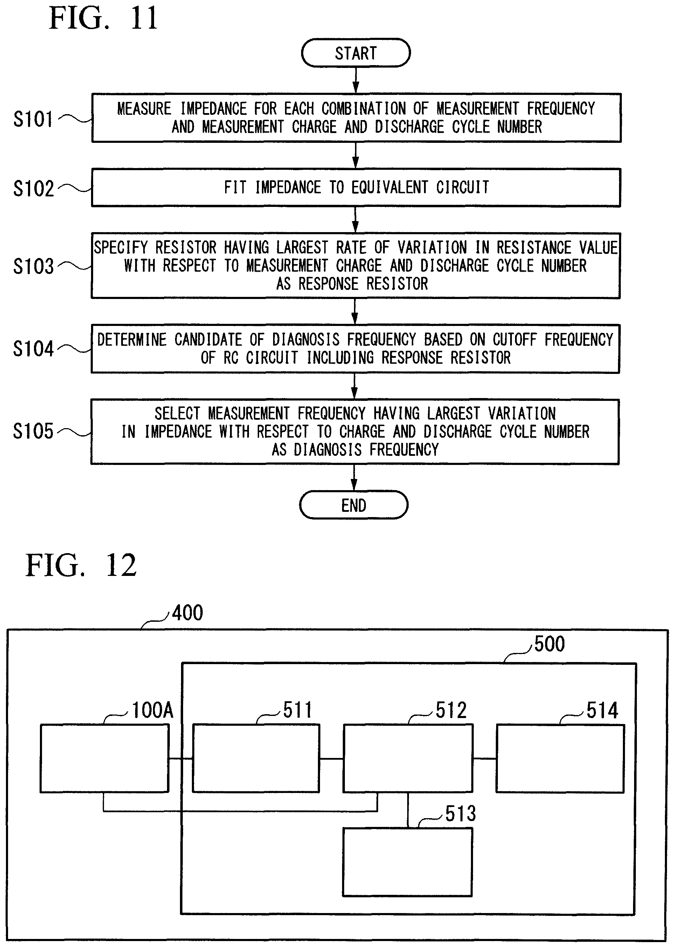

The flow diagram of FIG. 11 shows an example of a processing procedure executed by the system for determining a diagnosis frequency of the present embodiment in order to determine a diagnosis frequency corresponding to the storage cell 100.

First, the impedance measurement device 200 measures impedance by applying measurement frequencies which are set in a frequency range (for example, 0.01 Hz to 100 kHz) determined in advance, for each predetermined charge and discharge cycle number determined in advance (step S101).

In step S101, impedance according to each combination of the charge and discharge cycle number and the measurement frequency is measured. The impedance measured in this manner is input to the device for determining a diagnosis frequency 300.

In the device for determining a diagnosis frequency 300, the fitting unit 301 performs a process of fitting the impedance according to each combination of the charge and discharge cycle number and the measurement frequency to the equivalent circuit shown in FIG. 2 (step S102). As a result, as in FIG. 3, a constant according to each charge and discharge cycle number is obtained for each element of the equivalent circuit.

Next, the element specification unit 302 specifies a resistor having a largest rate of variation with respect to the charge and discharge cycle numbers of resistance values obtained by the fitting of step S102, among the resistors R1, R2, R3, and R4 in the equivalent circuit, as a response resistor (step S103).

Next, the frequency candidate determination unit 303 determines a candidate for a diagnosis frequency (step S104). Therefore, the frequency candidate determination unit 303 calculates the cutoff frequency of the RC circuit including the response resistor specified in step S103, and sets the calculated cutoff frequency to a reference frequency. The frequency candidate determination unit 303 determines measurement frequencies included in a certain range based on the reference frequency as candidates for a diagnosis frequency.

Next, the diagnosis frequency selection unit 304 determines a diagnosis frequency from the measurement frequencies of candidates determined in step S104 (step S105). Therefore, the diagnosis frequency selection unit 304 obtains a rate of variation according to the charge and discharge cycle number of impedance measured in response to each measurement frequency of a candidate. The diagnosis frequency selection unit 304 selects a measurement frequency having a largest obtained rate of variation as a diagnosis frequency.

As described above, the system for determining a diagnosis frequency of the present embodiment specifies a resistor having a largest variation in resistance value in the equivalent circuit, from results obtained by fitting the measurement results for the impedance of the storage cell. The system for determining a diagnosis frequency determines a candidate for a diagnosis frequency from the cutoff frequency of the CR circuit including the specified resistor. That is, the range of frequencies including a diagnosis frequency is narrowed down in the range of measurement frequencies. Moreover, rates of variation according to the charge and discharge cycle number of impedance for each measurement frequency of a candidate are compared with each other, and a measurement frequency corresponding to impedance having a largest rate of variation is determined as a diagnosis frequency.

In this manner, in the present embodiment, when the deterioration of the storage cell is diagnosed by measuring impedance using an AC impedance method, it is possible to accurately determine a diagnosis frequency made effective in a diagnosis.

Further, the system for determining a diagnosis frequency of the present embodiment determines a candidate for a diagnosis frequency, to thereby narrow down the range of frequencies including a diagnosis frequency in the range of measurement frequencies. Thereby, a rate of variation in impedance corresponding to only a measurement frequency serving as a candidate may be obtained in the determination of a diagnosis frequency, and it is not necessary to obtain rates of variation in impedances corresponding to all the measurement frequencies. Thereby, it is possible to achieve a reduction in a time required for the determination of a diagnosis frequency or a reduction in a processing load, and to efficiently determine a diagnosis frequency.

[Power Storage Device of the Present Embodiment with Diagnosis Function]

Subsequently, a power storage device in the present embodiment will be described. The power storage device of the present embodiment is included in equipment, such as a house or a facility, which is a target for power management, in the environment of a power management system such as, for example, a home energy management system (HEMS), a town energy management system (TEMS), or a community energy management system (CEMS). Alternatively, the power storage device of the present embodiment is included as electric power in an electric automobile or a hybrid car.

The power storage device in the present embodiment is configured to include a storage cell and a device for diagnosing deterioration of a storage cell. In the power storage device, the device for diagnosing deterioration of a storage cell performs a deterioration diagnosis on the storage cell at a predetermined timing. The device for diagnosing deterioration of a storage cell measures the impedance of the storage cell using an AC impedance method, and performs a deterioration diagnosis on the basis of the measured impedance. However, the device for diagnosing deterioration of a storage cell in the present embodiment does not measure impedance for each measurement frequency while changing the measurement frequency as in a general AC impedance method, and measures impedance at the diagnosis frequency determined by the system for determining a diagnosis frequency of the present embodiment.

As understood from the description of the aforementioned system for determining a diagnosis frequency, the diagnosis frequency is a measurement frequency having a most remarkable variation in impedance measured in accordance with the deterioration (charge and discharge cycle number) of the storage cell, among measurement frequencies used in a general AC impedance method.

The meaning of the diagnosis frequency having a most remarkable variation in impedance measured among measurement frequencies is that the determination (that is, deterioration diagnosis) of the degree of deterioration can be performed with sufficiently high reliability by collating impedance measured using the diagnosis frequency alone without using all the measurement frequencies with the measurement results of impedance measured for each charge and discharge cycle number in the same condition of the diagnosis frequency.

Reference will be made to FIG. 12 to describe a configuration example of a power storage device 400 of the present embodiment. As shown in the drawing, the power storage device 400 of the present embodiment includes a storage cell 100A and a device 500 for diagnosing deterioration of a storage cell.

The storage cell 100A is provided so as to accumulate power supplied from a commercial power supply, a power generation device or the like and supply the accumulated power to another load in a power management system. The storage cell 100A has the same specification as that of the storage cell 100 used for determining a diagnosis frequency in the system for determining a diagnosis frequency, for example, as shown in FIG. 1.

The device 500 for diagnosing deterioration of a storage cell performs a deterioration diagnosis on the storage cell 100A. The device 500 for diagnosing deterioration of a storage cell includes an impedance measurement unit 511, a deterioration diagnosis unit 512, a deterioration index information storage unit 513 and a diagnosis result output unit 514.

The impedance measurement unit 511 measures impedance by applying a signal of the diagnosis frequency determined by the system for determining a diagnosis frequency of the present embodiment to the storage cell. That is, the impedance measurement unit 511 in the present embodiment measures the impedance of the storage cell using an AC impedance method, and does not measure impedance according to each measurement frequency by applying an alternate current according to each of a plurality of measurement frequencies as in a general AC impedance method.

The impedance measurement unit 511 of the present embodiment performs the measurement of impedance by applying an alternate current based on only a single diagnosis frequency to the storage cell 100A.

The deterioration diagnosis unit 512 performs a deterioration diagnosis on the storage cell 100A by collating deterioration index information with the impedance measured by the impedance measurement unit 511. The deterioration index information is information indicating impedance measured on the basis of the diagnosis frequency in accordance with the degree of deterioration of the storage cell. The deterioration diagnosis unit 512 acquires the deterioration index information from the deterioration index information storage unit 513.

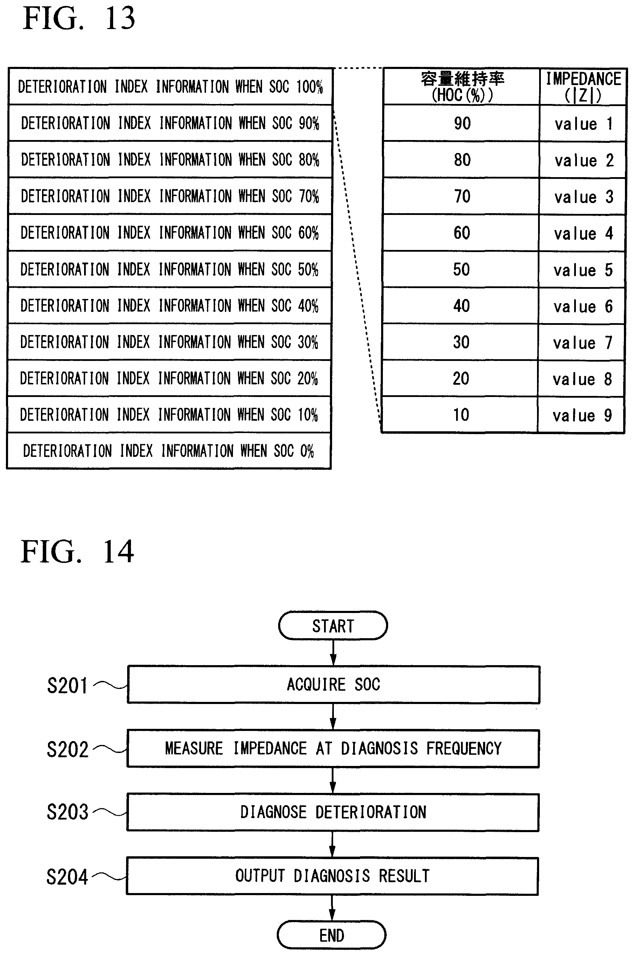

The deterioration index information storage unit 513 stores the deterioration index information. FIG. 13 shows an example of contents of the deterioration index information stored by the deterioration index information storage unit 513.

The deterioration index information is stored in the deterioration index information storage unit 513 in response to each predetermined state of charge (SOC), with respect to a storage cell (for example, storage cell 100 in FIG. 1) which is of the same type as that of the storage cell 100A. The state of charge is one of charge conditions of a storage cell, and refers to a ratio of power accumulated in a storage cell to power during full charge. The drawing shows an example in which eleven pieces of deterioration index information corresponding to respective SOCs of 100%, 90%, 80%, 70%, 60%, 50%, 40%, 30%, 20%, 10% and 0% are stored. One piece of deterioration index information indicates the correspondence of impedance to a capacity retention rate measured on the basis of the condition of a corresponding SOC. As described above, the capacity retention rate corresponds to the degree of deterioration.

In the deterioration index information in the drawing, an aspect is indicated in which impedances are associated with every ten capacity retention rates based on the interval of 10% like 90%, 80%, 70%, 60%, 50%, 40%, 30%, 20% and 10%. The number of capacity retention rates with which impedances are associated may be other than 10, and the value of each capacity retention rate may not be the interval of 10%.

In the deterioration index information of the drawing, impedance associated with for each capacity retention rate is set to an absolute value ($|Z|$). The impedance associated with each capacity retention rate may be a real part, and may be an imaginary part. Regarding which of the absolute value, the real part and the imaginary part is made to correspond to the capacity retention rate, an indication of a most remarkable variation according to the capacity retention rate may be selected from the measurement results.

In addition, as a measurement value obtained by measuring the state of the storage cell, a value indicating a relationship between the imaginary part and the real part of the impedance may be included in the measurement value, instead of the impedance, or in addition to the impedance. A specific example of the value indicating a relationship between the imaginary part and the real part of the impedance includes a phase difference $\phi$ ($\tan\phi$ = -(imaginary part)/(real part)).

For example, a relationship between the capacity retention rate and the impedance varies depending on the SOC of the storage cell even in a case where measurement is performed at the same diagnosis frequency. Consequently, the deterioration index information is provided for each of conditions of a plurality of different SOCs as in the present embodiment, and thus it is possible to estimate the capacity retention rate (that is, the degree of deterioration) with a high level of accuracy in association with the actual SOC of the storage cell 100A at a timing when a deterioration diagnosis is executed.

Description is given referring back to FIG. 12. The diagnosis result output unit 514 outputs a diagnosis result obtained by the deterioration diagnosis unit 512. As an aspect of the output of the diagnosis result, the diagnosis result output unit 514 can transmit, for example, the diagnosis result to a corresponding power management device. In this case, the power management device determines whether the storage cell 100A reaches its life span, on the basis of the degree of deterioration indicated by the diagnosis result, and informs a manager of that effect in a case where it is determined that the storage cell reaches its life span. The manager having received the information can appropriately perform maintenance, such as, for example, replace the storage cell 100A with a new storage cell.

Reference will be made to the flow diagram of FIG. 14 to describe an example of a processing procedure executed by the device 500 for diagnosing deterioration of a storage cell in the power storage device 400 of the present embodiment.

When the execution timing of a deterioration diagnosis is reached, the deterioration diagnosis unit 512 acquires a value of a current SOC from status information which is output by the storage cell 100A (step S201).

Here, the execution timing of a deterioration diagnosis can be set to, for example, a timing at which a certain period of time corresponding to the deterioration diagnosis has elapsed. In a case where the deterioration progress index value is set to the charge and discharge cycle number as in the present embodiment, the execution timing of a deterioration diagnosis can be set to a timing at which a predetermined number of times of charge and discharge has been performed.

The execution timing of a deterioration diagnosis may vary depending on the deterioration progress index value. As an example, in a case where the deterioration progress index value is an operating time, a deterioration diagnosis may be executed every time the operating time elapses beyond a certain period of time. In addition, in a case where an amount of accumulated charge or an amount of accumulated discharge is the deterioration progress index value, a deterioration diagnosis may be executed every time the amount of accumulated charge or the amount of accumulated discharge increases by a certain amount.

The impedance measurement unit 511 measures impedance by applying an alternate current based on a diagnosis frequency to the storage cell 100A (step S202).

Next, the deterioration diagnosis unit 512 performs a deterioration diagnosis (step S203). The deterioration diagnosis in step S203 is to acquire a capacity retention rate indicating the degree of deterioration of the storage cell 100A, and is performed, for example, as follows.

The deterioration diagnosis unit 512 sets deterioration index information to which the SOC acquired in step S201 corresponds, among pieces of deterioration index information for each SOC stored in the deterioration index information storage unit 513, to an object to be collated. The SOC acquired in step S201 is not necessarily coincident with the SOC at the interval of 10% associated with each deterioration index information, for example, as illustrated in FIG. 13. Consequently, in a case where the SOC acquired in step S201 is not coincident with the SOC of the deterioration index information, the deterioration diagnosis unit 512 makes the acquired SOC correspond to any SOC of the deterioration index information, in accordance with a predetermined rule (such as, for example, rounding off).

The deterioration diagnosis unit 512 collates the deterioration index information which is set to an object to be collated, with the impedance measured in step S202, and acquires a capacity retention rate corresponding to the impedance measured in step S202. Even in this case, the impedance measured in step S202 is not necessarily coincident with the impedance indicated in the deterioration index information. Consequently, the deterioration diagnosis unit 512 makes the impedance measured in step S202 correspond to, for example, impedance which is most approximate among impedances in the deterioration index information. The deterioration diagnosis unit 512 acquires a capacity retention rate associated with the impedance made to correspond to in the deterioration index information. In this manner, the deterioration diagnosis by the deterioration diagnosis unit 512 is performed.

The diagnosis result output unit 514 outputs a diagnosis result obtained in step S203 (step S204). Specifically, the diagnosis result output unit 514 can transmit, for example, a diagnosis result indicating the capacity retention rate acquired in step S203 to a high-order power management device.

In this manner, the power storage device 400 of the present embodiment can perform a deterioration diagnosis of the storage cell 100A. Here, the deterioration diagnosis of the storage cell in the present embodiment is performed by an AC impedance method using only a single diagnosis frequency. Thereby, the impedance measurement unit 511 in the present embodiment is not required to be configured in association with the application of an alternate current based on a large number of frequencies in a wide frequency range, and may be simply configured to apply an alternate current based on a single diagnosis frequency. The configuration of the impedance measurement unit 511 is simplified in this manner, and thus it is possible to achieve a reduction in size and a reduction in cost with respect to the device 500 for diagnosing deterioration of a storage cell including the impedance measurement unit 511. Thereby, as the power storage device 400 with a deterioration diagnosis function, small-sized and inexpensive device can be provided to a consumer to be managed by a power management system.

In the deterioration diagnosis of the present embodiment, since impedance may be measured at a single diagnosis frequency, it is possible to considerably shorten a time required for the measurement of impedance, as compared with a case where a plurality of measurement frequencies are used as in a general AC impedance method.

In the present embodiment, for example, deterioration index information corresponding to a single SOC may be provided.

In this case, it is possible to perform a diagnosis when the conditions of diagnosis execution such as, for example, the diagnosis period or the number of times of charge and discharge described above are satisfied, and then are set to the state of SOC in a certain range based on the SOC to which cycle deterioration index information corresponds.

There may be a case where a variation according to the SOC of a correspondence relation between the impedance and the capacity retention rate is small, or a case where a simple deterioration diagnosis which does not require a high level of accuracy is performed. In such a case, it is also possible to perform a deterioration diagnosis using deterioration index information corresponding to a single SOC, regardless of the SOC of the storage cell 100A.

<Second Embodiment>

Subsequently, a second embodiment will be described. The device 500 for diagnosing deterioration of a storage cell in the previous embodiment is included in the power storage device 400 having a deterioration diagnosis function. On the other hand, in the present embodiment, the device 500 for diagnosing deterioration of a storage cell is configured to be capable of moving in a state of being in hand or in-vehicle. A diagnosis worker goes to a facility equipped with a storage cell which is a target for diagnosis, and performs a deterioration diagnosis by connecting a device for diagnosing deterioration of a storage cell to the storage cell.

As described above, the device for diagnosing deterioration of a storage cell in the present embodiment may be configured to measure impedance at a single diagnosis frequency, and thus it is possible to achieve a reduction in size.

Therefore, as in the present embodiment, it is also possible to easily realize that the device for diagnosing deterioration of a storage cell is configured to be capable of moving by handhold or in-vehicle.

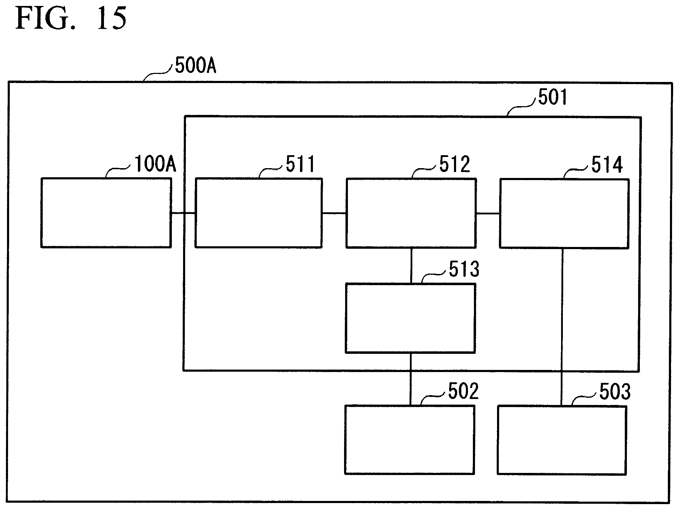

FIG. 15 shows a configuration example of a device 500A for diagnosing deterioration of a storage cell in the present embodiment. In the drawing, the same portions as those in FIG. 12 are denoted by the same reference numerals and signs, and thus the description thereof will not be given.

The device 500A for diagnosing deterioration of a storage cell in the present embodiment includes a control unit 501, an operating unit 502 and an output device unit 503.

The control unit 501 executes various control in the device 500A for diagnosing deterioration of a storage cell. The control unit 501 includes an impedance measurement unit 511, a deterioration diagnosis unit 512, a deterioration index information storage unit 513 and a diagnosis result output unit 514. That is, the control unit 501 has the same configuration as that of the device 500 for diagnosing deterioration of a storage cell in FIG. 12.

The operating unit 502 collectively shows an operator included in the device 500A for diagnosing deterioration of a storage cell and an operation device which is connected to the device 500A for diagnosing deterioration of a storage cell.

The output device unit 503 collectively shows an output device included in the device 500A for diagnosing deterioration of a storage cell and an output device which is connected to the device 500A for diagnosing deterioration of a storage cell. An example of the output device unit 503 includes a display unit, a printer or the like.

Deterioration diagnosis work of the storage cell 100A performed by the device 500A for diagnosing deterioration of a storage cell in the present embodiment is performed as follows.

A diagnosis worker connects the device 500A for diagnosing deterioration of a storage cell to the storage cell 100A, and then performs an operation for instructing the operating unit 502 to start a diagnosis. The control unit 501 executes a process relating to a deterioration diagnosis in the same procedure as that shown in the flow diagram of FIG. 14, in accordance with the operation of the diagnosis start instruction.

In the present embodiment, when the diagnosis result of step S204 is output, the diagnosis result output unit 514 can transmit the diagnosis result to a high-order power management device, as described above.

As the output of the diagnosis result of step S204, the diagnosis result output unit 514 can also cause the output device unit 503 to output the diagnosis result. For example, in the present embodiment, it is possible to display the diagnosis result on a display unit included in the output device unit 503, or to print the diagnosis result through a printer.

In this manner, the diagnosis result is output by the output device unit 503, a diagnosis worker can immediately ascertain the deterioration state of the storage cell 100A in a field. Thereby, for example, in a case where it is ascertained that the storage cell 100A deteriorates and reaches its life span, a diagnosis worker can rapidly take a measure such as the arrangement of replacement of the storage cell.

<Modification Example>

Hereinafter, a modification example of the present embodiment will be described.

[First Modification Example]

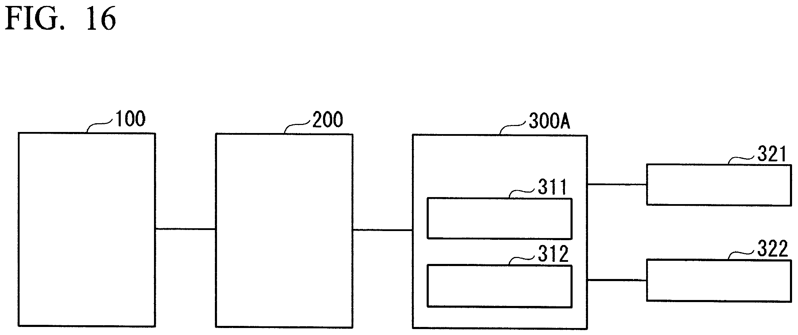

First, a first modification example will be described. FIG. 16 shows a configuration example of a system for determining a diagnosis frequency in the present modification example. In the drawing, the same portions as those in FIG. 1 are denoted by the same reference numerals and signs, and thus the description thereof will not be given. Differences from those in FIG. 1 will be mainly described.

The system for determining a diagnosis frequency in the drawing includes a device for determining a diagnosis frequency 300A, a display unit 321, and an operating unit 322.

The device for determining a diagnosis frequency 300A includes a plot information output unit 311 and an acceptance unit 312, as functional units relating to the determination of a diagnosis frequency. The plot information output unit 311 outputs plot information for each predetermined frequency which is obtained by plotting impedance measured by the impedance measurement device 200 in association with the progress of deterioration. The acceptance unit 312 accepts the selection of a diagnosis frequency from a plurality of frequencies corresponding to each output plot information.

The display unit 321 displays an image which is output by the device for determining a diagnosis frequency 300A.

The operating unit 322 collectively shows an operator or an input device included in the device for determining a diagnosis frequency 300A, or an operator or an input device which is connected to the device for determining a diagnosis frequency 300A.

As a specific example, the plot information output unit 311 generates a graph obtained by plotting impedance measured for each value of a predetermined charge and discharge cycle number, as the plot information, for each measurement frequency on a two-dimensional plane in which the charge and discharge cycle number which is a deterioration progress index value is set to a horizontal axis and the impedance is set to a vertical axis. The plot information output unit 311 displays a plurality of graphs corresponding to each measurement frequency on the display unit 321 in a predetermined aspect.

A user views graphs for respective measurement frequencies displayed on the display unit 321, and determines which of the graphs exhibits a most remarkable variation in impedance with respect to the charge and discharge cycle number. The user causes the operating unit 322 to perform an operation for selecting a measurement frequency corresponding to the graph determined to have a most remarkable variation in impedance from a plurality of measurement frequencies corresponding to the respective displayed graphs.

The acceptance unit 312 accepts the selection of a measurement frequency by the operation performed as described above. The acceptance unit 312 determines the selected measurement frequency as a diagnosis frequency.

In the above configuration, the selection of a measurement frequency is performed on the basis of a user's determination. For example, the device for determining a diagnosis frequency 300A may select plot information having a most remarkable variation in impedance with respect to the charge and discharge cycle number, using a predetermined algorithm (such as, for example, machine learning), from pieces of plot information corresponding to the respective measurement frequencies, and determine a measurement frequency corresponding to the selected plot information as a diagnosis frequency.

[Second Modification Example]

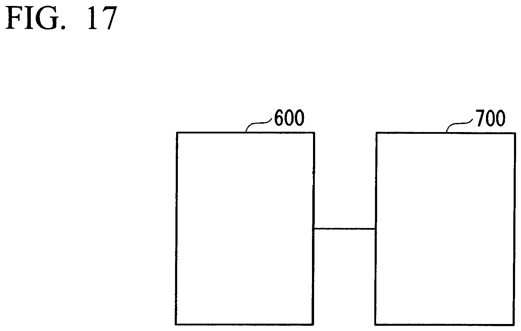

Subsequently, a second modification example will be described. FIG. 17 shows a configuration example of a system for determining a diagnosis frequency corresponding to the present modification example. The system for determining a diagnosis frequency in the drawing includes a storage unit 600 and an arithmetic operation unit 700.

The storage unit 600 stores the measurement value obtained by measuring the state of the storage cell. Specifically, the storage unit 600 stores impedance measured for each of a plurality of predetermined measurement frequencies, as a measurement value, in response to each predetermined charge and discharge cycle number (deterioration progress index value).

The arithmetic operation unit 700 determines a frequency corresponding to a measurement value having a characteristic variation with respect to the progress of deterioration of the storage cell, among measurement values stored by the storage unit 600, as a diagnosis frequency used in the diagnosis of deterioration of the storage cell. The specific configuration of the arithmetic operation unit 700 may be the same as that of, for example, the device for determining a diagnosis frequency 300 in FIG. 1, the device for determining a diagnosis frequency 300A in FIG. 16, or the like.

In the present modification example, the impedance as the measurement value stored by the storage unit 600 may be impedance actually measured by the impedance measurement device, or may be impedance obtained by the simulation of the storage cell.

[Third Modification Example]

In the description made so far, the impedance measurement unit 511 is configured to measure impedance at a single diagnosis frequency which is fixedly set. On the other hand, the impedance measurement unit 511 of the present embodiment can also be configured to measure impedance by switching, for example, a plurality of diagnosis frequencies determined in response to each of multiple types of storage cells.

For this purpose, for example, a diagnosis frequency table in which a type of storage cell and a diagnosis frequency are associated with each other is stored in the devices 500 and 500A for diagnosing deterioration of a storage cell. The impedance measurement unit 511 recognizes a type of storage cell 100A through communication with the storage cell 100A which is a target for diagnosis, and measures impedance at a diagnosis frequency associated with the recognized type. In a case of such a configuration, the deterioration index information storage unit 513 stores deterioration index information corresponding to each type of storage cell 100A, and the deterioration diagnosis unit 512 performs a deterioration diagnosis using the deterioration index information corresponding to the recognized type.

[Fourth Modification Example]

In the description made so far, a case has been described in which the system for determining a diagnosis frequency determines a single diagnosis frequency in response to one type of storage cell, and the device for diagnosing deterioration of a storage cell performs a deterioration diagnosis using the determined single diagnosis frequency.

However, in the present embodiment, for example, a configuration may be used in which a plurality of diagnosis frequencies are determined in response to one type of storage cell, and the deterioration diagnosis of the storage cell is performed using the plurality of determined diagnosis frequencies.

[Fifth Modification Example]

In the present embodiment, the measurement value obtained by measuring the state of the storage cell may be the characteristics of the storage cell obtained in accordance with the application of a signal to the storage cell, other than impedance. The impedance of the storage cell in the embodiment is obtained as the response characteristics for the application of an alternate-current signal in an AC impedance method, but the measurement value based on the present embodiment may be some kind of characteristics obtained in accordance with the application of a signal. For example, impedance or the like measured when a rectangular-wave signal is applied instead of an AC sinusoidal signal used in a general AC impedance method may be used as a measurement value.

A program for realizing the functions of the device 300 for determining a diagnosis frequency and the devices 500 and 500A for diagnosing deterioration of a storage cell, and the like described above is recorded in a computer readable recording medium, and thus the processes of the device 300 for determining a diagnosis frequency, the devices 500 and 500A for diagnosing deterioration of a storage cell, and the like described above may be performed by causing a computer system to read and execute the program recorded in this recording medium. Here, the wording "causing a computer system to read and execute the program recorded in the recording medium" includes installing the program in the computer system. The term "computer system" as used herein is assumed to include an OS or hardware such as peripheral devices. In addition, the "computer system" may include a plurality of computer devices connected to each other through the Internet or a network including a communication line such as WAN, LAN, or a dedicated line. The term "computer readable recording medium" refers to a flexible disk, a magneto-optic disc, a ROM, a portable medium such as a CD-ROM, and a storage device such as a hard disk built into the computer system. In this manner, the recording medium having a program stored thereon may be a non-transitory recording medium such as a CD-ROM.

An example of the recording medium also includes a recording medium provided inside or outside which is accessible from a delivery server in order to deliver the program. The code of the program stored in the recording medium of the delivery server may be different from the code of a program having a format capable of being executed in a terminal device. That is, a format stored in the delivery server does not matter insofar as the format is downloaded from the delivery server and can be installed in a format capable of being executed in a terminal device. Configurations in which a program is divided into a plurality of parts, and the divided parts are downloaded at different timings and then are merged in a terminal device, or delivery servers that deliver each of the divided programs may be different from each other. Further, the "computer readable recording medium" is assumed to include a recording medium that holds a program for a certain period of time, like a volatile memory (RAM) inside a computer system serving as a server or a client in a case where a program is transmitted through a network. The above-stated program may be a program which is used for realizing a portion of the functions described above. Further, the program may be a program which is capable of realizing the above-described functions by a combination of programs previously recorded in the computer system, or a so-called difference file (difference program).

Industrial Applicability

According to the present invention, an effect is obtained in which it is possible to accurately specify a frequency suitable for the deterioration diagnosis of the storage cell from frequencies used in an AC impedance method.

Reference Signs List

    100, 100A: storage cell
    200: impedance measurement device
    300, 300A: device for determining a diagnosis frequency
    301: fitting unit
    302: element specification unit
    303: frequency candidate determination unit
    304: diagnosis frequency selection unit
    400: power storage device
    500, 500A: device for diagnosing deterioration of a storage cell
    501: control unit
    502: operating unit
    503: output device unit
    511: impedance measurement unit
    512: deterioration diagnosis unit
    513: deterioration index information storage unit
    514: diagnosis result output unit
    600: storage unit
    700: arithmetic operation unit

**Claims**

1. A method for determining a diagnosis frequency, comprising:

    an impedance measurement step of measuring impedance of a storage cell corresponding to each predetermined frequency in association with progress of deterioration of the storage cell; and
    a diagnosis frequency determination step of determining a frequency corresponding to impedance having a characteristic variation in value with respect to the progress of deterioration, among the impedances measured in the impedance measurement step, as a diagnosis frequency for use in measurement based on an AC impedance method for performing a deterioration diagnosis on the storage cell.

2. The method for determining a diagnosis frequency according to claim 1, wherein the diagnosis frequency determination step includes
a fitting step of fitting the impedance measured in the impedance measurement step to an equivalent circuit corresponding to the storage cell,
an element specification step of specifying an element of which a parameter characteristically varies with respect to the progress of deterioration, among elements that form the equivalent circuit fitted in the fitting step,
a frequency candidate determination step of determining a candidate for a diagnosis frequency on the basis of a frequency having a characteristic response of a circuit including the element specified in the element specification step, and
a diagnosis frequency selection step of selecting a candidate for a diagnosis frequency corresponding to impedance having a characteristic variation in value with respect to the progress of deterioration, among impedances measured in response to each candidate for a diagnosis frequency determined in the frequency candidate determination step, as a diagnosis frequency.

3. The method for determining a diagnosis frequency according to claim 1, wherein the diagnosis frequency determination step includes
a plot information output step of outputting plot information for each predetermined frequency which is obtained by plotting the impedance measured in the impedance measurement step in association with the progress of deterioration, and
an acceptance step of accepting selection of a diagnosis frequency from a plurality of frequencies corresponding to each output plot information.

4. A method for diagnosing deterioration of a storage cell, comprising:

an impedance measurement step of measuring impedance by applying a signal, based on a diagnosis frequency determined using the method for determining a diagnosis frequency according to any one of claims 1 to 3, to a storage cell; and
a deterioration diagnosis step of performing a deterioration diagnosis of the storage cell by collating deterioration index information indicating the impedance measured on the basis of the diagnosis frequency in accordance with a degree of deterioration of the storage cell with the impedance measured in the impedance measurement step.

5. The method for diagnosing deterioration of a storage cell according to claim 4, wherein the deterioration index information indicates the impedance measured on the basis of the diagnosis frequency in accordance with the degree of deterioration of the storage cell in association with each charge state of the storage cell, and
wherein in the deterioration diagnosis step, a deterioration diagnosis of the storage cell is performed by collating impedance according to the degree of deterioration of the storage cell indicated in the deterioration index information in response to the charge state detected in the storage cell with the impedance measured in the impedance measurement step.

6. A system for determining a diagnosis frequency, comprising:

an impedance measurement unit that measures impedance of a storage cell corresponding to each predetermined frequency in association with progress of deterioration of the storage cell; and
a diagnosis frequency determination unit that determines a frequency corresponding to impedance having a characteristic variation in value with respect to the progress of deterioration, among the impedances measured by the impedance measurement unit, as a diagnosis frequency for use in measurement based on an AC impedance method for performing a deterioration diagnosis on the storage cell.

7. A system for determining a diagnosis frequency, comprising:

a storage unit that stores measurement values obtained by measuring a state of a storage cell; and
an arithmetic operation unit that determines a frequency corresponding to a measurement value having a characteristic variation with respect to progress of deterioration of the storage cell, among the measurement values stored by the storage unit, as a diagnosis frequency for use in a diagnosis of the deterioration of the storage cell.

8. The system for determining a diagnosis frequency according to claim 7, wherein the measurement value is characteristics of the storage cell which are measured in accordance with application of a signal to the storage cell.

9. The system for determining a diagnosis frequency according to claim 8, wherein the characteristics of the storage cell are response characteristics of the storage cell which are measured in accordance with application of a signal to the storage cell.

10. The system for determining a diagnosis frequency according to claim 9, wherein the response characteristics of the storage cell are impedance of the storage cell which is measured in a state where a signal is applied to the storage cell.

11. A device for diagnosing deterioration of a storage cell, comprising:

an impedance measurement unit that measures impedance by applying a signal, based on a diagnosis frequency determined by the system for determining a diagnosis frequency according to any one of claims 6 to 10, to a storage cell; and a deterioration diagnosis unit that performs a deterioration diagnosis of the storage cell by collating deterioration index information indicating the impedance measured on the basis of the diagnosis frequency in accordance with a degree of deterioration of the storage cell with the impedance measured by the impedance measurement unit.

FIG. 1

FIG. 2

# FIG. 3

| cycle | 0 | 150 | 300 | 450 | 600 | 750 | 900 | 1050 | 1200 | 1350 | 1500 | 1650 | 1800 | 1950 | 2100 | 2250 | 2400 | 2550 | 2700 | 2850 | 3000 |
|---|---|---|---|---|---|---|---|---|---|---|---|---|---|---|---|---|---|---|---|---|---|
| capacity | 100.0% | 98.7% | 96.9% | 94.4% | 93.3% | 99.7% | 89.9% | 88.8% | 87.2% | 85.8% | 84.3% | 83.4% | 82.3% | 80.8% | 79.4% | 78.6% | 77.1% | 75.9% | 75.2% | 73.7% | 72.9% |
| L (*e5) | 8.40E-03 | | | 6.08E-03 | 4.94E-03 | 7.12E-03 | 9.36E-03 | 5.75E-03 | 5.40E-03 | 3.10E-03 | 4.25E-03 | 1.49E-02 | 1.32E-02 | 1.40E-02 | 1.12E-02 | 1.23E-02 | 1.32E-02 | 9.19E-03 | 1.51E-02 | 1.15E-02 | 1.66E-02 |
| RL | 0.030035 | | | 0.015242 | 0.013488 | 0.01805 | 0.032943 | 0.021534 | 0.016418 | 0.0094901 | 0.014016 | 0.054111 | 0.056218 | 0.045173 | 0.04882 | 0.04708 | 0.060141 | 0.029648 | 0.057161 | 0.057387 | 0.10958 |
| Rs | 0.0007457 | | | 0.0007151 | 0.0007316 | 0.0007634 | 0.0006872 | 0.0009496 | 0.0008142 | 0.0006631 | 0.0006747 | 0.0007117 | 0.0007281 | 0.0009563 | 0.0007299 | 0.0007347 | 0.0007305 | 0.0007664 | 0.0008215 | 0.0007625 | 0.0007218 |
| R1 | 0.0002193 | | | 1.41E-04 | 1.31E-04 | 1.46E-04 | 1.25E-04 | 1.26E-04 | 1.08E-04 | 6.16E-05 | 8.87E-05 | 1.28E-04 | 1.13E-04 | 1.35E-04 | 1.01E-04 | 1.16E-04 | 1.29E-04 | 1.12E-04 | 1.35E-04 | 1.18E-04 | 1.09E-04 |
| C1 | 6.752 | | | 11.17 | 9.515 | 10.81 | 13.28 | 13.87 | 14.1 | 17.53 | 12.68 | 18.93 | 18.99 | 23.54 | 18.39 | 18.68 | 20.43 | 20.28 | 27.05 | 16.91 | 18.36 |
| R2 | 8.63E-05 | | | 1.48E-04 | 1.58E-04 | 1.34E-04 | 1.02E-04 | 1.09E-04 | 1.17E-04 | 1.28E-04 | 1.15E-04 | 1.14E-04 | 1.03E-04 | 1.29E-04 | 1.12E-04 | 1.17E-04 | 1.30E-04 | 1.19E-04 | 1.78E-04 | 1.28E-04 | 1.25E-04 |
| C2 | 73.74 | | | 61.57 | 45.86 | 80.56 | 117.3 | 116.1 | 86.55 | 52.32 | 58.16 | 174.7 | 151.1 | 205.2 | 133.6 | 148.3 | 174 | 157.9 | 220.2 | 134.1 | 133.9 |
| R3 | 2.20E-05 | | | 3.07E-04 | 3.72E-04 | 4.03E-04 | 3.45E-04 | 4.56E-04 | 5.14E-04 | 4.75E-04 | 4.73E-04 | 6.86E-04 | 6.32E-04 | 8.11E-04 | 6.66E-04 | 7.34E-04 | 8.41E-04 | 7.15E-04 | 8.99E-04 | 8.00E-04 | 7.00E-04 |
| C3 | 1797 | | | 210.1 | 169.5 | 195.9 | 202.4 | 189.3 | 180.3 | 196.2 | 176 | 188.5 | 190.3 | 198.5 | 215.4 | 205.2 | 189.3 | 213.5 | 228.5 | 186.3 | 195 |
| R4 | 1.81E-05 | | | 1.39E-04 | 1.60E-04 | 1.73E-04 | 1.49E-04 | 2.01E-04 | 2.64E-04 | 4.92E-04 | 4.48E-04 | 3.06E-04 | 3.88E-04 | 4.30E-04 | 6.58E-04 | 5.64E-04 | 4.70E-04 | 6.04E-04 | 4.10E-04 | 5.88E-04 | 5.63E-04 |
| C4 | 11206 | | | 2648 | 1937 | 1989 | 1655 | 1576 | 1339 | 700.4 | 607.7 | 1485 | 1013 | 1252 | 734.2 | 925.7 | 1307 | 881.7 | 2053 | 1022 | 997 |
| Wo1-R | 1.24E-03 | | | 2.36E-02 | 2.00E-02 | 1.91E-02 | 1.31E-02 | 1.59E-02 | 1.70E-02 | 1.92E-02 | 1.42E-02 | 1.64E-02 | 1.44E-02 | 1.71E-02 | 2.20E-02 | 2.13E-02 | 1.82E-02 | 2.13E-02 | 2.16E-02 | 1.63E-02 | 1.70E-02 |
| Wo1-T | 9.18E-01 | | | 182.9 | 182.7 | 197.8 | 183 | 205.4 | 211.9 | 195.7 | 220.6 | 231.6 | 218.8 | 204.7 | 201.4 | 214.2 | 233.3 | 197.3 | 208.1 | 263.1 | 232.3 |
| Wo1-P | 0.6364 | | | 0.85542 | 0.84069 | 0.81787 | 0.78662 | 0.7897 | 0.79264 | 0.78125 | 0.75451 | 0.77396 | 7.52E-01 | 7.70E-01 | 7.77E-01 | 7.84E-01 | 7.73E-01 | 7.85E-01 | 8.07E-01 | 7.04E-01 | 7.27E-01 |
| τ1 | 1.480E-03 | | | 1.575E-03 | 1.246E-03 | 1.578E-03 | 1.654E-03 | 1.754E-03 | 1.520E-03 | 1.080E-03 | 1.124E-03 | 2.431E-03 | 2.139E-03 | 3.173E-03 | 1.852E-03 | 2.162E-03 | 2.626E-03 | 2.262E-03 | 3.659E-03 | 1.995E-03 | 2.009E-03 |
| τ2 | 6.366E-03 | | | 9.094E-03 | 7.250E-03 | 1.076E-02 | 1.195E-02 | 1.260E-02 | 1.010E-02 | 6.701E-03 | 6.698E-03 | 1.998E-02 | 1.562E-02 | 2.649E-02 | 1.494E-02 | 1.730E-02 | 2.255E-02 | 1.878E-02 | 3.920E-02 | 1.721E-02 | 1.669E-02 |
| τ3 | 3.638E-02 | | | 6.453E-02 | 6.299E-02 | 7.897E-02 | 6.985E-02 | 8.640E-02 | 9.272E-02 | 9.326E-02 | 8.325E-02 | 1.293E-01 | 1.202E-01 | 1.699E-01 | 1.434E-01 | 1.507E-01 | 1.592E-01 | 1.526E-01 | 2.054E-01 | 1.490E-01 | 1.365E-01 |
| τ4 | 2.024E-01 | | | 3.693E-01 | 3.091E-01 | 3.444E-01 | 2.463E-01 | 3.165E-01 | 3.538E-01 | 3.448E-01 | 2.724E-01 | 4.545E-01 | 3.932E-01 | 5.385E-01 | 4.829E-01 | 5.224E-01 | 6.148E-01 | 5.327E-01 | 8.419E-01 | 6.009E-01 | 5.631E-01 |
| f1 | 107.5 | | | 101.1 | 127.7 | 100.8 | 96.2 | 90.7 | 104.7 | 147.3 | 141.5 | 65.5 | 74.4 | 50.2 | 85.9 | 73.6 | 60.6 | 70.4 | 43.5 | 79.8 | 79.2 |
| f2 | 25.0 | | | 17.5 | 22.0 | 14.8 | 13.3 | 12.6 | 15.8 | 23.8 | 23.8 | 8.0 | 10.2 | 6.0 | 10.7 | 9.2 | 7.1 | 8.5 | 4.1 | 9.2 | 9.5 |
| f3 | 4.4 | | | 2.5 | 2.5 | 2.0 | 2.3 | 1.8 | 1.7 | 1.7 | 1.9 | 1.2 | 1.3 | 1.0 | 1.1 | 1.1 | 1.0 | 1.0 | 0.8 | 1.1 | 1.2 |
| f4 | 0.8 | | | 0.4 | 0.5 | 0.5 | 0.6 | 0.5 | 0.4 | 0.5 | 0.6 | 0.4 | 0.4 | 0.3 | 0.3 | 0.3 | 0.3 | 0.3 | 0.2 | 0.3 | 0.3 |

# FIG. 4

# FIG. 5

Legend:
- ―――― No02_SOC0_n1.z
- ·············· 25deg100%450cyc(SOC0%)-1-1.z
- —·—·— 25deg100%3000cyc(SOC0%)-1-1.z

# FIG. 6

# FIG. 7

Legend:
- No02_SOC0_n1.z
- 25deg100%450cyc(SOC0%)-1-1.z
- 25deg100%3000cyc(SOC0%)-1-1.z

Upper plot: $|Z|$ vs Frequency (Hz)
Lower plot: theta vs Frequency (Hz)

# FIG. 8

EP 3 385 737 A1

# FIG. 9

EP 3 385 737 A1

FIG. 10

EP 3 385 737 A1

# FIG. 11

```
                    ( START )
                        │
                        ▼
S101 ──┌─────────────────────────────────────────────┐
       │ MEASURE IMPEDANCE FOR EACH COMBINATION OF    │
       │ MEASUREMENT FREQUENCY AND MEASUREMENT CHARGE │
       │        AND DISCHARGE CYCLE NUMBER            │
       └─────────────────────────────────────────────┘
                        │
                        ▼
S102 ──┌─────────────────────────────────────────────┐
       │        FIT IMPEDANCE TO EQUIVALENT CIRCUIT   │
       └─────────────────────────────────────────────┘
                        │
                        ▼
S103 ──┌─────────────────────────────────────────────┐
       │ SPECIFY RESISTOR HAVING LARGEST RATE OF      │
       │ VARIATION IN RESISTANCE VALUE WITH RESPECT   │
       │ TO MEASUREMENT CHARGE AND DISCHARGE CYCLE    │
       │        NUMBER AS RESPONSE RESISTOR           │
       └─────────────────────────────────────────────┘
                        │
                        ▼
S104 ──┌─────────────────────────────────────────────┐
       │ DETERMINE CANDIDATE OF DIAGNOSIS FREQUENCY   │
       │ BASED ON CUTOFF FREQUENCY OF RC CIRCUIT      │
       │        INCLUDING RESPONSE RESISTOR           │
       └─────────────────────────────────────────────┘
                        │
                        ▼
S105 ──┌─────────────────────────────────────────────┐
       │ SELECT MEASUREMENT FREQUENCY HAVING LARGEST  │
       │ VARIATION IN IMPEDANCE WITH RESPECT TO       │
       │ CHARGE AND DISCHARGE CYCLE NUMBER AS         │
       │        DIAGNOSIS FREQUENCY                   │
       └─────────────────────────────────────────────┘
                        │
                        ▼
                    ( END )
```

# FIG. 12

# FIG. 13

| DETERIORATION INDEX INFORMATION WHEN SOC 100% |
| --- |
| DETERIORATION INDEX INFORMATION WHEN SOC 90% |
| DETERIORATION INDEX INFORMATION WHEN SOC 80% |
| DETERIORATION INDEX INFORMATION WHEN SOC 70% |
| DETERIORATION INDEX INFORMATION WHEN SOC 60% |
| DETERIORATION INDEX INFORMATION WHEN SOC 50% |
| DETERIORATION INDEX INFORMATION WHEN SOC 40% |
| DETERIORATION INDEX INFORMATION WHEN SOC 30% |
| DETERIORATION INDEX INFORMATION WHEN SOC 20% |
| DETERIORATION INDEX INFORMATION WHEN SOC 10% |
| DETERIORATION INDEX INFORMATION WHEN SOC 0% |

| 容量維持率<br>(HOC(%)) | IMPEDANCE<br>($|Z|$) |
| --- | --- |
| 90 | value 1 |
| 80 | value 2 |
| 70 | value 3 |
| 60 | value 4 |
| 50 | value 5 |
| 40 | value 6 |
| 30 | value 7 |
| 20 | value 8 |
| 10 | value 9 |

# FIG. 14

START

S201 ACQUIRE SOC

S202 MEASURE IMPEDANCE AT DIAGNOSIS FREQUENCY

S203 DIAGNOSE DETERIORATION

S204 OUTPUT DIAGNOSIS RESULT

END

# FIG. 15

FIG. 16

FIG. 17

## INTERNATIONAL SEARCH REPORT

| International application No. |
| --- |
| PCT/JP2016/085509 |

**A. CLASSIFICATION OF SUBJECT MATTER**

*G01R31/36*(2006.01)i, *G01R27/02*(2006.01)i, *H01M10/42*(2006.01)i, *H01M10/48*
(2006.01)i

According to International Patent Classification (IPC) or to both national classification and IPC

**B. FIELDS SEARCHED**

Minimum documentation searched (classification system followed by classification symbols)
G01R31/36, G01R27/02, H01M10/42, H01M10/48

Documentation searched other than minimum documentation to the extent that such documents are included in the fields searched
Jitsuyo Shinan Koho     1922-1996   Jitsuyo Shinan Toroku Koho   1996-2017
Kokai Jitsuyo Shinan Koho  1971-2017   Toroku Jitsuyo Shinan Koho   1994-2017

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>A | JP 5-281310 A (Nippon Telegraph and Telephone Corp.),<br>29 October 1993 (29.10.1993),<br>paragraphs [0001], [0008] to [0018]; fig. 1, 2, 3<br>(Family: none) | 1,4,6-11<br>2-3,5 |
| X<br>A | WO 2015/011872 A1 (GS Yuasa International Ltd.),<br>29 January 2015 (29.01.2015),<br>paragraphs [0001], [0007] to [0008], [0014] to [0017], [0022] to [0028], [0041] to [0052], [0074] to [0127]; fig. 2 to 7B, 9A to 10B<br>& US 2016/0195588 A1<br>fig. 2 to 7B, 9A to 10B; paragraphs [0001], [0007] to [0008], [0031] to [0033], [0039] to [0045], [0058] to [0069], [0091] to [0144] | 7-10<br>1-6,11 |

☒ Further documents are listed in the continuation of Box C.     ☐ See patent family annex.

| | |
| --- | --- |
| *   Special categories of cited documents:<br>"A"   document defining the general state of the art which is not considered   to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search<br>    03 February 2017 (03.02.17) | Date of mailing of the international search report<br>    14 February 2017 (14.02.17) |
| --- | --- |
| Name and mailing address of the ISA/<br>   Japan Patent Office<br>   3-4-3,Kasumigaseki,Chiyoda-ku,<br>   Tokyo 100-8915,Japan | Authorized officer<br><br><br>Telephone No. |

Form PCT/ISA/210 (second sheet) (January 2015)

**EP 3 385 737 A1**

**INTERNATIONAL SEARCH REPORT**

International application No.

PCT/JP2016/085509

C (Continuation). DOCUMENTS CONSIDERED TO BE RELEVANT

| Category* | Citation of document, with indication, where appropriate, of the relevant passages | Relevant to claim No. |
|---|---|---|
| A | WO 2013/054813 A1 (Waseda University), 18 April 2013 (18.04.2013), paragraphs [0001], [0010] to [0037]; fig. 1, 4 to 9 & US 2014/0287287 A1 fig. 1, 4 to 9; paragraphs [0001], [0022] to [0052] | 1-11 |
| A | JP 2013-29412 A (Yokogawa Electric Corp.), 07 February 2013 (07.02.2013), paragraphs [0001], [0013] to [0014], [0030] to [0055]; fig. 1 to 4 & US 2013/0030737 A1 fig. 1 to 4D; paragraphs [0003], [0016] to [0019], [0049] to [0075] & EP 2551689 A2     & CN 102901929 A | 1-11 |
| A | JP 2010-160055 A (Toyota Motor Corp.), 22 July 2010 (22.07.2010), paragraphs [0001], [0005], [0008] to [0017]; fig. 1, 3, 4 (Family: none) | 1-11 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015234007 A
- JP 2016146626 A
- JP 2014134467 A

**Non-patent literature cited in the description**

- **COREY T. LOVE ; MAHEBOOB B.V. VIRJI ; RICHARD E. ROCHELEAU ; KAREN E. SWIDER-LYONS.** State-of-health monitoring of 18650 4S packs with a single-point impedance diagnostic. *Journal of Power Sources,* 20 May 2014, vol. 266, 512-519